# EUROPÄISCHE PATENTSCHRIFT

(11) **EP 0 679 689 B1**
(45) Veröffentlichungstag und Bekanntmachung des Hinweises auf die Patenterteilung: **26.09.2001**
(21) Anmeldenummer: 95104008.8
(22) Anmeldetag: 18.03.1995
(51) Int. Cl.: C08L 67/02, C08L 67/06, C08G 63/52, C08J 3/28

(54) **Polyester-Formkörper mit ausgezeichneter thermischer Stabilität**
Moulded parts with excellent thermic stability
Articles moulés avec stabilité thermique excellente

(30) Priorität: 29.04.1994 DE 4415095
(43) Veröffentlichungstag der Anmeldung: 02.11.1995
(73) Patentinhaber: Degussa AG, 40474 Düsseldorf (DE)
(72) Erfinder: Kleine Homann, Walter, Dr., D-48249 Dülmen (DE); Finke, Jürgen, Dr., D-45770 Marl (DE); Grosse-Puppendahl, Thomas, D-45721 Haltern (DE); von der Bey-Dahm, Eva, Dr., D-45721 Haltern (DE); Biela, Dieter, D-45699 Herten (DE)

(56) Entgegenhaltungen:
- EP-A2- 0 559 072
- EP-A2- 0 644 218

## Beschreibung

Gegenstand der Erfindung sind Formkörper mit ausgezeichneter thermischer Stabilität auf Basis hochmolekularer Polyester, die olefinische Doppelbindungen aufweisen.

Formkörper auf der genannten Polyesterbasis sind aus der EP-A-0 559 072 bekannt. Jedoch sind die dort in erster Linie eingesetzten langkettigen Verbindungen sehr kostspielig und darüber hinaus nur äußerst schlecht zugänglich. Zwar wird bei den als wesentlich beschriebenen Verfahrensparametern eine Erhöhung der Wärmeformbeständigkeit erzielt, jedoch reicht diese nicht aus, um eine kurzzeitige thermische Belastung, wie sie bei verschiedenen Lötverfahren in der Elektrotechnik (Badlöten, Reflow-Löten) auftritt, ohne sichtbare Schädigung bzw. Verformung zu überstehen. Üblicherweise werden Bauteile bei dieser Technologie Temperaturen von 200 bis 400 °C über einen Zeitraum von 3 bis 60 Sekunden ausgesetzt.

Nach dem Stand der Technik werden hierfür unter anderem hochtemperaturbeständige Thermoplaste wie beispielsweise Polyphenylensulfid (PPS), Polyetherimid (PEI) oder Polyetheretherketon (PEEK) verwendet. Hierbei erweisen sich jedoch zum einen die hohen Verarbeitungstemperaturen von 300 bis 400 °C und zum anderen der hohe Preis als nachteilig.

Aufgabe der vorliegenden Erfindung war es demnach, Formkörper aus Polyesterformmassen zu ermöglichen, die einfach und kostengünstig herzustellen sind und die darüber hinaus die kurzzeitige thermische Belastung bei den in der Elektrotechnik üblichen Lötverfahren unbeschadet überstehen.

Diese Aufgabe wird erfindungsgemäß dadurch gelöst, daß die Formkörper auf Polyestern basieren, die aus Einheiten aufgebaut sind, welche sich von folgenden Monomeren herleiten:
A. organische Dicarbonsäure und
B.
   a. 0 bis 99,9 Mol-% eines Alkandiols oder Cycloalkandiols mit 2 bis 12 C-Atomen in der Kohlenstoffkette und
   b. 0,1 bis 100 Mol-% eines Alkendiols mit 4 bis 12 C-Atomen in der Kohlenstoffkette
und daß sie nach der Formgebung einer Behandlung mit ionisierender Strahlung unterworfen worden sind, wobei in den Fällen, in denen die Komponente B mehr als 2,5 Mol-% Alkendiol enthält, die eingestrahlte Dosis im Bereich oberhalb von 200 bis maximal 2 000 kGy liegt, und in den Fällen, in denen die Komponente B 0,1 bis 2,5 Mol-% Alkendiol enthält, die eingestrahlte Dosis im Bereich oberhalb von 400 bis maximal 2 000 kGy liegt.

Die Polyester werden durch Veresterung oder Umesterung und anschließende Polykondensation von organischen Dicarbonsäuren oder deren polyesterbildenden Derivaten sowie dem entsprechenden Diolgemisch in Gegenwart von Katalysatoren hergestellt (Sorenson und Campbell, Preparative Methods of Polymer Chemistry, Interscience Publishers Inc., (N. Y.), 1961, Seiten 111 bis 127; Kunststoff-Handbuch, Band VIII, C. Hanser Verlag München, 1973; J. Polym. Sci., Part A 1, 4, Seiten 1851 bis 1859, 1966).

Die Reaktionstemperaturen liegen hierbei im Bereich von 160 bis 350 °C, vorzugsweise im Bereich von 170 bis 280 °C. Die genannte Reaktion wird unter weitgehendem Ausschluß von Sauerstoff durchgeführt. Aus diesem Grunde wird bei der Veresterung oder Umesterung vorzugsweise in einer Inertgasatmosphäre gearbeitet. Als Inertgas eignen sich z. B. Edelgase, Stickstoff, Kohlendioxid etc. Die Polykondensationsstufe wird bevorzugt im Vakuum durchgeführt.

Als organische Dicarbonsäure werden (cyclo)aliphatische und vorzugsweise aromatische Säuren, ggf. auch im Gemisch, eingesetzt. Sie weisen 2 bis 36, vorzugsweise 4 bis 18 C-Atome im Kohlenstoffgerüst auf.

Als (cyclo)aliphatische Säuren seien beispielsweise 1.4-Cyclohexandicarbonsäure, Adipinsäure, Sebacinsäure, Azelainsäure, Decandicarbonsäure und Dimerfettsäuren genannt; als aromatische Säuren kommen hauptsächlich Phthalsäure, Isophthalsäure, Naphthalindicarbonsäure und insbesondere Terephthalsäure in Frage. Die Säuren können jeweils einzeln oder auch im Gemisch eingesetzt werden. Anstelle der freien Säuren können mit Vorteil auch deren Derivate, wie z. B. Ester, insbesondere Methylester, eingesetzt werden.

Die Diolkomponente B. a. wird durch Alkandiole oder Cycloalkandiole mit 2 bis 12 C-Atomen in der Kohlenstoffkette gebildet. Beispielsweise sind hierbei Ethylenglykol, Butandiol-1.4, Hexandiol-1.6, 1.4- bzw. 1.3-Dimethylolcyclohexan oder Neopentylglykol geeignet. Selbstverständlich können hierbei auch Gemische verschiedener Diole eingesetzt werden.

Als Alkendiol (Komponente B. b.) werden bevorzugt Verbindungen mit 4 bis 6 C-Atomen in der Kohlenstoffkette, wie z. B. 2-Butendiol-1.4, 3-Hexendiol-1.6, 2-Pentendiol-1.5 oder 3-Methyl-2-pentendiol-1.5, verwendet. Besonders bevorzugt wird 2-Butendiol-1.4 eingesetzt.

Das Alkendiol wird vorzugsweise in Mengen von 1 bis 40 Mol-% eingesetzt.

Unter den Begriff Polyester werden auch Blockcopolyester gerechnet. Derartige Produkte werden z. B. in Chimia 28 (9), Seiten 544 bis 552 (1974) und in Rubber Chemistry and Technology 50, Seiten 688 bis 703 (1977) beschrieben. Diese Blockcopolyester enthalten neben den obengenannten aromatischen Dicarbonsäuren und Diolen ein Poly(oxyalkylen)diol mit einem Molgewicht im Bereich von etwa 600 bis 2 500. Bevorzugte Poly(oxyalkylen)diole sind Poly(oxyethylen)diol, Poly(oxypropylen)diol und Poly(oxytetramethylen)diol. Der Anteil der Poly(oxyalkylen)diole liegt im Bereich von 4 bis 40 Gew.-%, vorzugsweise von 10 bis 35 Gew.-% (bezogen auf den gesamten Blockcopolyester).

Nach Beendigung der Polykondensation weisen die Polyester üblicherweise eine Viskositätszahl im Bereich von 50 bis 200 cm³/g, vorzugsweise 70 bis 180 cm³/g, auf.

Die zur Herstellung der erfindungsgemäßen Formkörper eingesetzten Formmassen können noch Hilfs- und Zusatzstoffe enthalten. Hierfür kommen z. B. Nucleierungs-, Mattierungs-, Fließmittel oder andere Verarbeitungshilfsmittel sowie Pigmente, Füll- und Verstärkungsstoffe, Flammschutzmittel und Schlagzähmacher in Frage.

Nucleierungs-, Mattierungs-, Fließmittel und andere Verarbeitungshilfsmittel können in Mengen bis zu 6 Gew.-%, bevorzugt von 0,2 bis 3,5 Gew.-%, in den Formmassen enthalten sein.

Pigmente, Füll- und Verstärkungsstoffe, Flammschutzmittel und Schlagzähmacher sind in Mengen bis zu 60 Gew.-%, bevorzugt von 1 bis 50 Gew.-%, in den Formmassen enthalten.

Die erfindungsgemäßen Formkörper können auf üblichen Maschinen, z. B. im Spritzguß oder durch Extrusion, hergestellt werden.

Zu Formkörpern gemäß der Erfindung werden nicht nur Formteile mit ausgeprägter Dreidimensionalität, sondern auch Filme, Folien, Fasern etc. gezählt.

Nach der Formgebung werden die erhaltenen Formkörper einer Behandlung mit ionisierenden Strahlen unterworfen. Für diesen Arbeitsgang werden beispielsweise marktübliche Quellen für β- oder γ-Strahlen eingesetzt. So können als β-Strahlenquelle Elektronenstrahlbeschleuniger mit einer Leistung von 150 kV bis 5 MV und als γ-Strahlenquellen z. B. Co⁶⁰- bzw. Cs¹³⁷-Präparate mit hoher Strahlungsleistung verwendet werden.

Die erforderliche Dosis für die eingestrahlte ionisierende Strahlung liegt oberhalb von 200 bis maximal bei 2 000 kGy und insbesondere im Bereich von 300 bis 1 000 kGy.

Das erfindungsgemäße Verfahren zeichnet sich durch folgende Vorteile aus:
- die bestrahlten Formkörper können kurzzeitig sehr hoch thermisch belastet werden, z. B. in einem Schwallötbad bei 250 bis 260 °C oder sogar höher;
- die erfindungsgemäßen Formkörper können durch die für Thermoplaste üblichen Verarbeitungsverfahren wie Spritzgießen oder Extrudieren hergestellt werden;
- die mechanischen Eigenschaften wie Zugfestigkeit, Schlagzähigkeit etc. werden durch die Bestrahlung positiv beeinflußt.

Formkörper, die nach dem erfindungsgemäßen Verfahren hergestellt wurden, eignen sich besonders für Einsatzgebiete, in denen eine hohe kurzzeitige thermische Belastbarkeit gefordert ist, z. B. für lötbadbeständige elektrische Bauelemente wie z. B. Steckverbinder, Relais, Widerstände, Kondensatoren, Halbleiterbauelemente sowie als Folien für gedruckte Schaltungen. Profile, Rohre, Ummantelungen und Hohlkörper können ebenfalls hergestellt werden.

Im folgenden soll die Erfindung beispielhaft erläutert werden. Die mit Buchstaben gekennzeichneten Versuche sind nicht erfindungsgemäß.

### Beispiele

### Herstellung der Polyesterformmassen

Die Zusammensetzung der erfindungsgemäßen Polyesterformmassen ist in Tabelle 1 angegeben. Die Polyester wurden durch Umesterung und anschließende Polykondensation von Dimethylterephthalat mit dem aufgeführten Diolgemisch unter Verwendung von iso-Propyltitanat als Katalysator nach den bekannten Verfahren hergestellt.

### Herstellung der Probekörper

Zur Ermittlung der mechanischen Eigenschaften und der Lötbadbeständigkeit wurden Zugstäbe S3 nach DIN 53455 sowie Flachstäbe (80 x 10 x 4 mm) im Spritzgießverfahren bei Verarbeitungstemperaturen von 240 bis 260 °C und Formtemperaturen von 60 bis 80 °C hergestellt. Anschließend wurden die Probekörper einer β-Strahlung mit den in Tabelle 1 aufgeführten Strahlungsdosen ausgesetzt.

### Bestimmung der anwendungstechnischen Eigenschaften

Der Zugversuch zur Bestimmung von Streckspannung, Streckdehnung und Reißfestigkeit wurde an bestrahlten Probekörpern (Zugstab S3) entsprechend DIN 53455 durchgeführt. Die Bestimmung der Schlagzähigkeit erfolgte entsprechend ISO 180 1U. Die Prüfung zur Lötbadbeständigkeit erfolgte in einem flüssigen Metallbad (Wood'sche Legierung) bei 250 °C und 260 °C. Hierzu wurden die Probekörper jeweils 10 Sekunden vollständig in das Metallbad eingetaucht und anschließend visuell beurteilt.

### Vergleichsbeispiele (mit Buchstaben gekennzeichnet)

Aufgrund der Unzugänglichkeit der in EP-A-0 559 072 beschriebenen Diolkomponente 10-Eicosen-1.20-diol (keine CAS-Nr.) wurden die Vergleichsversuche mit 2-Buten-1.4-diol durchgeführt und entsprechend der dort angegebenen Strahlungsdosis von 100 kGy bestrahlt. Die Probekörper wiesen nach dem Eintauchen in das flüssige Metallbad bei 250 °C deutlich sichtbare Verformungen auf. Darüber hinaus war die Oberfläche angeschmolzen.

**Tabelle 1**

| **Zusammensetzung** | | | |
|---|---|---|---|
| Beispiel | Diolkomponente in Mol-% | | Strahlungsintensität in kGy |
| | B1D* | B2D** | |
| A | 99 | 1 | 100 |
| 1 | 99 | 1 | 600 |
| B | 95 | 5 | 100 |
| 2 | 95 | 5 | 250 |
| 3 | 95 | 5 | 400 |
| 4 | 95 | 5 | 600 |
| C | 75 | 25 | 100 |
| 5 | 75 | 25 | 250 |
| 6 | 75 | 25 | 400 |
| 7 | 75 | 25 | 600 |
| 8 | 75 | 25 | 1 000 |

| | | | |
|---|---|---|---|
| *B1D = 1.4-Butandiol | | | |
| **B2D = 2-Buten-1.4-diol | | | |

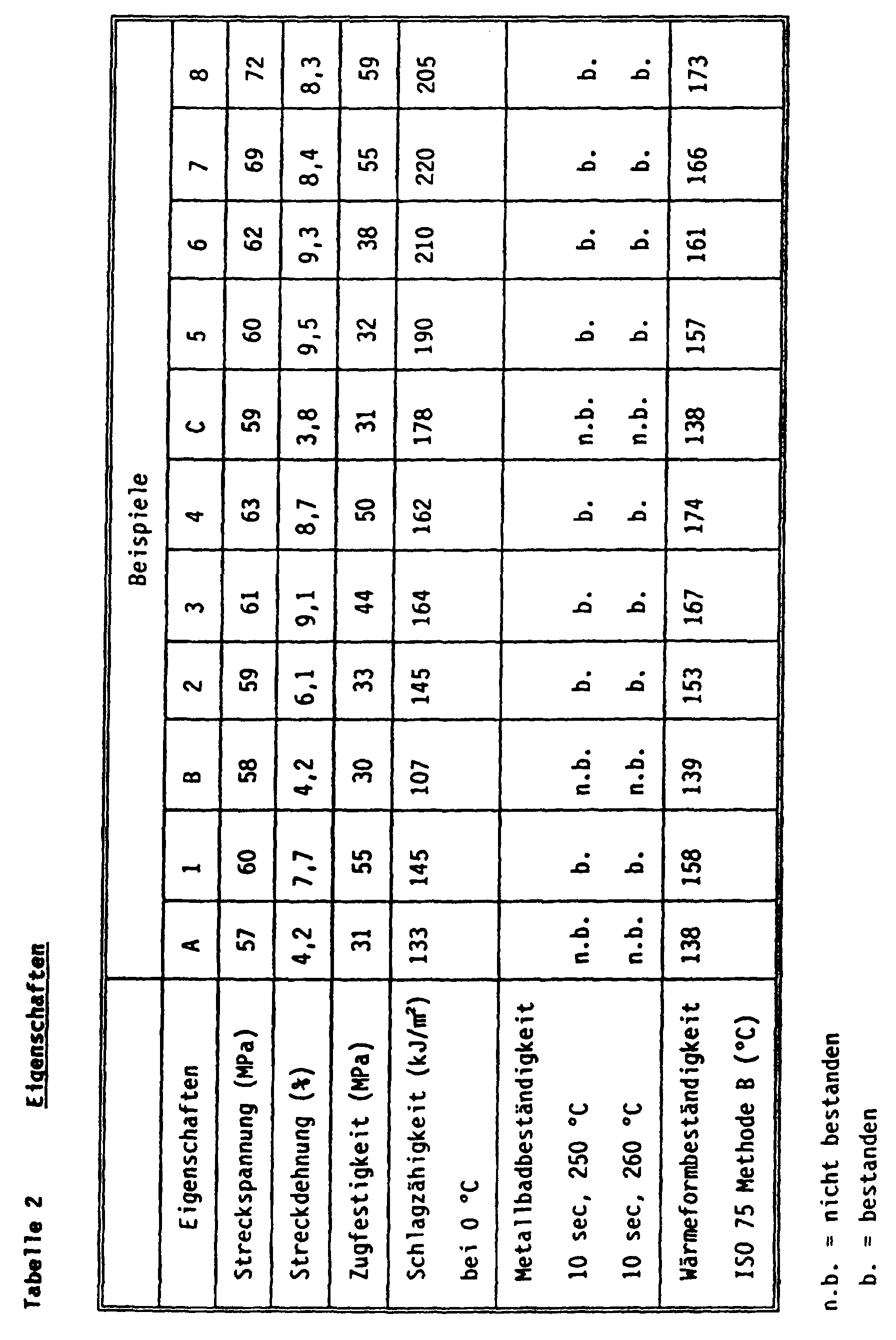

## Patentansprüche

1. Lötbadbeständiger Formkörper auf Basis von Polyestern, die olefinische Doppelbindungen aufweisen,
**dadurch gekennzeichnet,**
**daß** die Polyester aus Einheiten aufgebaut sind, welche sich von folgenden Monomeren herleiten:
A. organische Dicarbonsäure und
B.
a. 0 bis 99,9 Mol-% eines Alkandiols oder Cycloalkandiols mit 2 bis 12 C-Atomen in der Kohlenstoffkette und
b. 0,1 bis 100 Mol-% eines Alkendiols mit 4 bis 12 C-Atomen in der Kohlenstoffkette
und daß sie nach der Formgebung einer Behandlung mit ionisierender Strahlung unterworfen worden sind, wobei in den Fällen, in denen die Komponente B mehr als 2,5 Mol-% Alkendiol enthält, die eingestrahlte Dosis im Bereich oberhalb von 200 bis maximal 2 000 kGy liegt, und in den Fällen, in denen die Komponente B 0,1 bis 2,5 Mol-% Alkendiol enthält, die eingestrahlte Dosis im Bereich oberhalb von 400 bis maximal 2 000 kGy liegt.

2. Formkörper gemäß Anspruch 1,
**dadurch gekennzeichnet,**
**daß** die Komponente A eine aromatische Dicarbonsäure ist.

3. Formkörper gemäß einem der vorhergehenden Ansprüche,
**dadurch gekennzeichnet,**
**daß** die Komponente B. b. zu 1 bis 40 Mol-% enthalten ist.

4. Formkörper gemäß einem der vorhergehenden Ansprüche,
**dadurch gekennzeichnet,**
**daß** die Komponente B. b. 4 bis 6 C-Atome in der Kohlenstoffkette enthält.

5. Formkörper gemäß Anspruch 4,
**dadurch gekennzeichnet,**
**daß** die Komponente B. b. 2-Butendiol-1.4 ist.

6. Formkörper gemäß einem der vorhergehenden Ansprüche,
**dadurch gekennzeichnet,**
**daß** er mit β- oder γ-Strahlung als ionisierender Strahlung behandelt worden ist.

7. Formkörper gemäß einem der vorhergehenden Ansprüche,
**dadurch gekennzeichnet,**
**daß** die eingestrahlte Dosis im Bereich von 300 bis 1 000 kGy liegt.

## Claims

1. A shaped article which is resistant to soldering baths and is based on a polyester which contains olefinic double bonds, **characterized in that** the polyester is built up from units which are derived from the following monomers:
A. organic dicarboxylic acid and
B.
a. 0 to 99.9 mol % of an alkanediol or cycloalkanediol having 2 to 12 C atoms in the carbon chain and
b. 0.1 to 100 mol % of an alkenediol having 4 to 12 C atoms in the carbon chain
and in that, after shaping, it has been subjected to a treatment with ionizing radiation, the irradiated dose being in the range above 200 to not more than 2,000 kGy in cases where component B comprises more than 2.5 mol % of alkenediol and the irradiated dose being in the range above 400 to not more than 2,000 kGy in cases where component B comprises 0.1 to 2.5 mol % of alkenediol.

2. A shaped article according to claim 1, **characterized in that** component A is an aromatic dicarboxylic acid.

3. A shaped article according to either one of the preceding claims, **characterized in that** the composition comprises component B. b. to the extent of 1 to 40 mol %.

4. A shaped article according to any one of the preceding claims, **characterized in that** component B. b. contains 4 to 6 C atoms in the carbon chain.

5. A shaped article according to claim 4, **characterized in that** component B. b. is 2-butene-1,4-diol.

6. A shaped article according to any one of the preceding claims, **characterized in that** it has been treated with β- or γ-radiation as the ionizing radiation.

7. A shaped article according to any one of the preceding claims, **characterized in that** the irradiated dose is in the range from 300 to 1,000 kGy.

## Revendications

1. Solide moulé résistant à la soudure, à base de polyesters possédant des doubles liaisons oléfiniques,
**caractérisé en ce que**
les polyesters sont constitués d'unités qui dérivent des monomères suivants :
A) des acides dicarboxyliques organiques et
B)
a) de 0 à 99,9 % molaire d'un alkanediol ou d'un cycloalkanediol ayant de 2 à 12 atomes de carbone dans la chaîne carbonée et
b) de 0,1 à 100 % molaire d'un alkènediol ayant de 4 à 12 atomes de carbone dans la chaîne carbonée, et
ceux-ci ont été soumis après le moulage à un traitement par un rayonnement ionisant dans lequel, dans les cas où le composant B renferme plus de 2,5 % molaire d'alkènediol, la dose irradiée se situe dans la zone au-dessus de 200 à au maximum 2000 kGy, et dans les cas où le composant B renferme de 0,1 à 2,5 % molaire d'alkènediol, la dose irradiée se situe dans la zone allant de 400 à au maximum 2000 kGy.

2. Solide moulé selon la revendication 1,
**caractérisé en ce que**
le composant A est un acide dicarboxylique aromatique.

3. Solide moulé selon l'une quelconque des revendications précédentes,
**caractérisé en ce que**
le composant B b) est contenu pour 1 à 40 % molaire.

4. Solide moulé selon l'une quelconque des revendications précédentes,
**caractérisé en ce que**
le composant B b) renferme de 4 à 6 atomes de carbone dans la chaîne carbonée.

5. Solide moulé selon la revendication 4,
**caractérisé en ce que**
le composant B b) est du 2-butènediol-1,4.

6. Solide moulé selon l'une quelconque des revendications précédentes,
**caractérisé en ce qu'**
il a été traité avec un rayonnement β ou γ en tant que rayonnement ionisant.

7. Solide moulé selon l'une quelconque des revendications précédentes,
**caractérisé en ce que**
la dose irradiée se situe dans la zone allant de 300 à 1000 kGy.
